# EUROPEAN PATENT SPECIFICATION

(11) **EP 2 360 114 B1**
(45) Date of publication and mention of the grant of the patent: **12.12.2012**
(21) Application number: 10153537.5
(22) Date of filing: 12.02.2010
(51) Int. Cl.: B81C 99/00, H01M 8/00, B81C 1/00, B01J 19/00

(54) **Method of producing a polymer stamp for the reproduction of devices comprising microstructures and nanostructures and corresponding device**
Verfahren zur Herstellung eines Polymerstempels zum Abformen von Vorrichtungen mit Mikro- und Nanostrukturen und entsprechende Vorrichtung
Procédé de production d'un timbre en polymère pour la reproduction de dispositifs comprenant des microstructures et des nanostructures et dispositif correspondant

(43) Date of publication of application: 24.08.2011
(73) Proprietor: Consejo Superior De Investigaciones Científicas, 28006 Madrid (ES); Helmholtz-Zentrum Berlin für Materialien und Energie GmbH, 14109 Berlin (DE)
(72) Inventor: Esquivel Bojorquez, Juan Pablo, 08023, Barcelona (ES); Senn, Tobias, 8004 Zürich (CH); Lörgen, Marcus, 15738, Zeuthen (DE); Sabaté Vizcarra, Neus, 08014, Barcelona (ES); Cané Ballart, Carles, 08221, Terrassa (ES)
(74) Representative: Gulde Hengelhaupt Ziebig & Schneider

(56) References cited:
- EP-A2- 1 495 799
- US-A1- 2009 041 986
- US-A1- 2009 047 478
- TRISTAN PICHONAT ET AL: "Recent developments in MEMS-based miniature fuel cells" MICROSYSTEM TECHNOLOGIES ; MICRO AND NANOSYSTEMS INFORMATION STORAGE AND PROCESSING SYSTEMS, vol. 13, no. 11-12, 4 January 2007 (2007-01-04), pages 1671-1678, XP019518816 SPRINGER, BERLIN, DE ISSN: 1432-1858 DOI: 10.1007/S00542-006-0342-5
- ZHOU Y A ET AL: "An air-breathing silicon-based micro direct methanol fuel cell with a capillary-based water drawn out structure", PROCEDDINGS OF TRANSDUCERS 2009., 21 June 2009 (2009-06-21), - 25 June 2009 (2009-06-25), pages 648-651, XP031545326, IEEE, PISCATAWAY, NJ, USA ISBN: 978-1-4244-4190-7

## Description

### Field of the invention

The present invention relates to a method of producing a polymer stamp for the reproduction of devices comprising microstructures and nanostructures, a polymer stamp and a device comprising microstructures and nanostructures. It particularly relates to micro devices which could be used in micro fuel cell system as fuel delivery systems or water management systems with microstructures and nanostructures. The device preferably consists of a polymer.

### Background of the invention

Different fields of technology like nanotechnology, biotechnology or optics need fabrication techniques and materials for future development. Due to an integration of nano- and microstructures, highly functional devices in applications like fluidics, biochips or photonic crystals could be achieved. Different micro- and nanofabrication processes and three dimensional microstructure techniques are known. The growing need of polymeric devices has led to a greater importance of polymer based micromachining. Because of the variety of polymeric materials they offer good biocompatibility and chemical resistance as well as good optical properties for photonic applications.

The main replication techniques of polymer based devices are injection moulding and hot embossing and micro-machining. For nanopattern replication, nanoimprint technology (NIL) and UV-nanoimprint-technology can be used. Besides, soft lithography techniques like microcontact printing (CP) and micro-moulding have been established which offer new possibilities of nanostructuring.

However, with hot embossing it is difficult to replicate positive and negative structural features due to the different conditions during moulding. Furthermore, it is difficult to form through-holes by hot embossing. Through-holes are for instance necessary for micro fuel cell systems. Injection moulding on the other hand normally requires expensive equipment.

For further improvement of fuel cells some general problems have to be solved. One of the problems is the fuel delivery. The fuel must be transported to the anode, where the reaction takes place. During the reaction, CO₂ is produced, which must be transported out of the system to avoid a hindrance for the fuel. Therefore the separation of liquid and gas and the transportation of gas out of the device is a decisive factor for the improvement of fuel cells. Both problems can be solved by exploiting wetting properties of surfaces. For example, fuel used in such applications can easily be transported to the anode through hydrophilic channels. The CO₂ on the other hand can be separated and transported out of the device through hydrophobic channels. Thus, a device that is capable to solve those problems may contain both hydrophobic and hydrophilic channels. Besides the transportation problems, the fuel must be supplied to the system. Therefore a through-hole for fuel supply must be integrated in such a device as well, which is difficult to form with hot embossing.

From US 20060029858 A1 a diffusion medium for use in a PEM fuel cell contains hydrophobic and hydrophilic areas for improved water management. A hydrophobic polymer such as a fluororesin is used to define hydrophobic areas, and an electroconductive polymer such as polyaniline or polypyrrole is used for defining hydrophilic areas. However, two different polymers need to be used for the formation of such channels making the fabrication process very complex.

DE 102 32 129 A1 discloses a fluid distribution device for an electrochemical electrode, wherein coatings are used to form hydrophobic and hydrophilic areas. However, a coating exhibits a limited lifetime. Moreover, each final product needs to be coated separately with the coating in order to produce hydrophobic and hydrophilic areas.

EP 1 495 799 A2 discloses a microfluidic device formed in a polymer substrate. Regular patterns of ridges, notches or columns provide areas of enhanced wettability within a fluidic duct of the device.

US 2009/0041986 A1 discloses a method of making hierarchical articles than contain nanofeatures and microstructures by first providing a substrate that includes nanofeatures and then creating microstructures by adding a layer. US 2009/0047478 A1 also discloses a method for forming hierarchical patterns on an article by nanoimprinting. Zhou et al ("An air-breathing silicon-based micro direct methanol fuel cell with a capillary-based water drawn out structure", PROCEEDINGS OF TRANSDUCERS 2009, 21 June 2009 (2009-06-21), - 25 June 2009 (2009-06-25), pages 648-651, XP031545326, IEEE, PISCATAWAY, NJ, USA, ISBN:978-1-4244-4190-7) discloses a capillary-based cathode structure for air-breathing micro direct methanol fuel cells. An array of capillaries with hydrophilic surfaces is designed on ribs of a cathode window to draw out excessive water from the cathode.

### Summary of the invention

It is therefore an object of the present invention to provide a method of producing a polymer stamp as well as a device from the polymer stamp, in which the nanostructures and microstructures are incorporated into the stamp and are transferred to the final device from the stamp. It is also an object to provide a passive device for a fuel cell system, which exhibits hydrophobic and hydrophilic areas in a simplified way at lower costs for separation of gaseous by-products from liquid fuels.

Accordingly, in a first embodiment the present invention provides a method of producing a polymer stamp for the reproduction of devices comprising microstructures and nanostructures, the method comprising the steps of providing a first substrate, patterning nanostructures extending along a first direction into the first substrate material, followed by patterning microstructures onto the first substrate, casting a polymer elastomer onto the first substrate with nanostructures and microstructures to form a polymer stamp and releasing the polymer stamp. The step of pattering microstructures comprises at least one of the steps of forming first microstructures to extend along the first direction to form hydrophilic channels together with the nanostructures extending in said first direction, and forming second microstructures to extend along a second direction different from the first direction to form hydrophobic channels together with the nanostructures extending in the first direction.

The process has the advantage that the nanostructures are formed directly into the substrate surface. The substrate preferably consists of a single material or material compound but may also comprise different layers of materials. By using a casting method on the nanostructured and microstructured substrate, the nanostructures and microstructures can be directly transferred to the polymer stamp at low costs. The direct integration of nanostructured areas in microdevices improves the functionality of the device, e.g. the formation of antireflection structures for optical applications or the change of wetting properties in microchannels.

Further, the invention is directed to a method of reproducing devices comprising microstructures and nanostructures comprising the steps of casting a final product material onto the polymer stamp with microstructures and nanostructures produced according to the invention as described above, wherein the microstructures and nanostructures are transferred during the casting step to the final product, and releasing the final product of the polymer stamp. The final product or device is preferably also a polymer device.

The device being formed is preferably a microdevice.

According to the invention, a simple and low cost casting step on the polymer stamp can be employed to repeatedly form the final product under the transfer of micro- and nanostructures to the final product.

It is emphasized that the stamp exhibits the inverse structure of the final product. Thus, a bottom of the channel in the final product will be a top in the stamp. However, for ease of reading and understanding, in the following we will usually refer to the orientation of the structures of the final product instead of the stamp, unless specifically stated otherwise.

The step of patterning nanostructures into the first substrate material preferably comprises the step of forming hydrophilic sections along a first direction and hydrophobic sections along a second, different direction by arranging the nanostructures to extend along a first direction. The second direction is preferably perpendicular to the first direction.

Thus, through the provision of the nanostructures in the substrate surface, hydrophilic and hydrophobic areas can be created in the respective surfaces without any additional layers or chemical coatings. The surfaces are functionalized by topographic nanostructures .

Advantageously, by aligning the microstructures with the nanostructures, hydrophilic channels can be created. The channels have the microstructures as the side walls and the nanostructures are formed at least on the bottom of the microstructures. The microstructures provide guides for a fluid along the direction in which the nanostructures are formed. However, along a different, second direction, the nanostructures become more and more hydrophobic. The maximum of hydrophobicity is established in a direction perpendicular to the first direction. If microstructures are now formed along this second, preferably perpendicular direction as well, hydrophobic and hydrophilic structures are formed simply by the mutual alignment or misalignment of nano- and microstructures.

The step of patterning microstructures preferably further comprises at least one of the steps of forming the first microstructures with a width of 50-500µm, preferably 100-200µm and a height of 10-1000µm, preferably 50-200µm, and forming the second microstructures with a width of 1-100µm, preferably 5-50µm and a height of 10-1000µm, preferably 50-200µm.

The size ranges of the microstructures improve their desired functionality as hydrophilic or hydrophobic channels.

The step of patterning nanostructures comprises at least one of the steps of forming the nanostructures with a pitch of 50nm-3500nm, preferably 500-1000nm and/or providing the nanostructures with a cross-section being triangular, rectangular or pillar-shaped and forming the nanostructure as lines and spaces. The aspect ratio of the height to the width of the nanostructures is preferably 1:2. The maximum height of the nanostructures is preferably lower than 1µm.

The size ranges of the nanostructures or -patterns maximize their distinguishing character of being hydrophilic in a first direction and hydrophobic in a second, different direction.

The lines and spaces provide a very simple way to direct fluids into their direction of extension. In the direction of the lines and spaces, the nanostructures are hydrophilic. In a second, different direction, their character becomes hydrophobic, with a maximum of hydrophobicity along the perpendicular direction.

The step of patterning nanostructures into the first substrate material preferably comprises the steps of covering the first substrate with a first resist, transferring nanostructures into the first resist by means of nanolithography processes, covering the first substrate with the nanostructured first resist with a metal layer, removal of the first resist with the metal on top, wherein the first substrate areas without the resist remain covered by the metal, forming nanostructures into the parts of the first substrate not covered with the metal by etching the surface of the first substrate using the remaining metal as a mask, and removing the metal from the first substrate.

The nanolithography processes are preferably UV lithography, nanoimprint lithography, hot-embossing, electron-beam lithography, interference lithography or X-ray interference lithography.

The microstructure patterning step may comprise the step of covering the first substrate with a second resist being a photo resist and performing a lithography process.

Advantageously, lithography processes are well known, easy to handle and can be used to form very precise structures. For instance, UV lithography, electron-beam lithography, interference lithography or X-ray lithography may be used.

The second resist preferably comprises polymethylmethacrylate, phenolic resins or epoxy-resins.

The microstructure patterning step preferably comprises the step of forming a through hole through the second resist and the first substrate.

The through-hole may be formed by potassium hydroxide etching, deep reactive ion etching, microdrilling or -milling, or laser ablation.

Advantageously, the casting step of the stamp and the final product allows to easily incorporate a through-hole into the final product required for instance in fuel cell applications. The through-hole and the micro- and nanostructures are formed in the final product in a single casting step.

Prior to the step of casting a polymer elastomer onto the first substrate the method may further comprise the steps of cutting the first substrate to obtain a pre-master comprising the nanostructured first substrate and the microstructured resin, and fixing the pre-master on a second substrate.

The polymer elastomer preferably comprises polydimethylsiloxane (PDMS). PDMS has advantageously a relative low absorption rate for UV applications.

The final product material used for casting preferably comprises polymer materials. It may comprise a photo resin, an epoxy-based resin, a thermal-curing material, an UV curing material, or a thermoplastic material. Polymer materials in general have the advantage of a good biocompatibility and chemical stability and resistance against fuels like ethanol and methanol as well as good optical properties.

Additionally, the present invention is directed to a polymer stamp comprising first micro-channels extending along a first direction, second micro-channels extending along a second direction, and nanostructures formed at least on one surface of the first and/or second micro-channels of the polymer stamp, the nanostructures being provided to extend at least along said first direction. The nanostructures are patterned directly into at least one surface of the microchannels.

In other words, the nanostructures are formed of the same material as the microstructures themselves. They may be formed of the same material as the bulk material of the polymer stamp. In any case, no additional chemical layers are necessary. The topography of the polymer stamp material itself is physically changed at its surface. Preferably, the stamp consists of a single material or material compound and the nanostructures are formed of this stamp material. The surface is functionalized by the topographic structure.

Furthermore, the invention provides a device comprising first microchannels extending along a first direction, second micro-channels extending along a second direction, different from the first direction, and nanostructures formed at least on the bottom of the first and/or second microchannels and provided to extend at least along said first direction. The nanostructures are patterned into the surface of the microchannels and are formed of the same material as microchannels themselves. A through-hole is provided extending from one surface of the device to be in communication with the microchannels, and the nanostructures and the first and second microchannels form hydrophilic channels along the first direction and hydrophobic channels along the second direction.

Preferably, the device consists of a single material or material compound and the nanostructures are formed of this device material. No additional layers, no coating or chemical treatment with molecules is required. The topography of the polymer stamp material is physically changed at its surface. The surface is functionalized by the topographic structures.

The device is preferably a single, fully integrated component. An assembly is not required.

The microchannels consist of the microstructures as the side walls, wherein at least on the bottom of the microchannel the nanostructures are provided. They may also be provided on the side walls and top wall of the microchannels.

The nanostructures provide a contact angles of 0°-90°, preferably 30°-75° along the first direction, and 90°-160°, preferably 110-150°along the second direction. Preferably, they have a pitch of 70nm-3500nm, more preferably 500-1000nm. The aspect ratio of the height to the width of the nanostructures is preferably 1:2. The maximum height of the nanostructures is preferably lower than 1 µm. The nanostructures are preferably provided with a cross-section being triangular, rectangular or pillar-shaped. They may be provided as lines and spaces. The lines extend along the first direction.

The first micro-channels have a width of 50-500µm, preferably 100-200µm and a height of 10-1000µm, preferably 50-200µm. The second micro-channels have a width of 1-100µm, preferably 5-50µm and a height of 10-1000µm, preferably 50-200µm.

The device is preferably a micro-device. In one embodiment, the device forms a part of a micro fuel cell system wherein the device is preferably a fuel delivery system, the first microchannels are fuel delivery microchannels, and the second microchannels are gas exhaust microchannels and the through-hole is a fuel supply. In another embodiment, the device is a water management system of a fuel cell system, the first microchannels are water outlet microchannels, the second microchannels are used as reactant supplies and the through-hole is a water exit. The reactant is preferably oxygen.

Thus, the device according to the invention can be used in fuel cell applications, wherein the separation of liquids and gases and the transportation of gases out of the device is achieved by the relative arrangement of first microstructures along the direction of extension of nanostructures on the one hand and second microstructures along a second, different, preferably perpendicular direction thereto on the other hand.

The hydrophobic surfaces of the microchannels can be used for gas separation. The microstructures, preferably the second microstructures may form openings in side walls of the device for the separation/exhaust of gaseous by-products created during operation of the fuel cell.

The microchannels allow advantageously a passive flow of fluids.

The transport is capillary and diffusion driven and therefore the device of the present invention can be used as a passive device for a fuel cell system. The transport is alsoorientation independent. The device can be easily integrated or bonded to a micro fuel cell system.

### Brief description of the drawings

These and other features and aspects of the present invention will become apparent and more readily appreciated from the following description of some exemplary embodiments, taken in conjunction with the accompanying drawings of which:
- Fig. 1: shows a first step of producing a polymer stamp according to a first embodiment, the provision of a substrate,
- Fig. 2: shows a substrate of Fig. 1 covered with a first resist,
- Fig. 3: shows a nanostructured substrate of Fig. 2,
- Fig. 4: shows the nanostructured substrate of Fig. 3 covered with a second resist,
- Fig. 5: shows the nanostructured substrate with microstructures formed on top,
- Fig. 6: shows a pre-master comprising microstructures and nanostructures and a through-hole,
- Fig. 7: shows the pre-master of Fig. 6 attached to a second substrate,
- Fig. 8: shows the polymer stamp casting,
- Fig. 9: shows the polymer stamp,
- Fig. 10: shows the cast final product,
- Fig. 11: shows a top view of the polymer stamp of Fig. 9,
- Fig. 12: shows a cut through the polymer stamp of Fig. 11 along the line A-A,
- Fig. 13: shows the casting step of the final product using the stamp of Fig. 12,
- Fig. 14: shows a cut through a final product of a first embodiment along a corresponding to line A-A of Fig. 12,
- Fig. 15: shows a fuel cell application of two devices according to a present invention,
- Fig. 16: shows a contact angle measurement of nanostructures parallel to their direction of extension and perpendicular thereto.

### Detailed description of the drawings

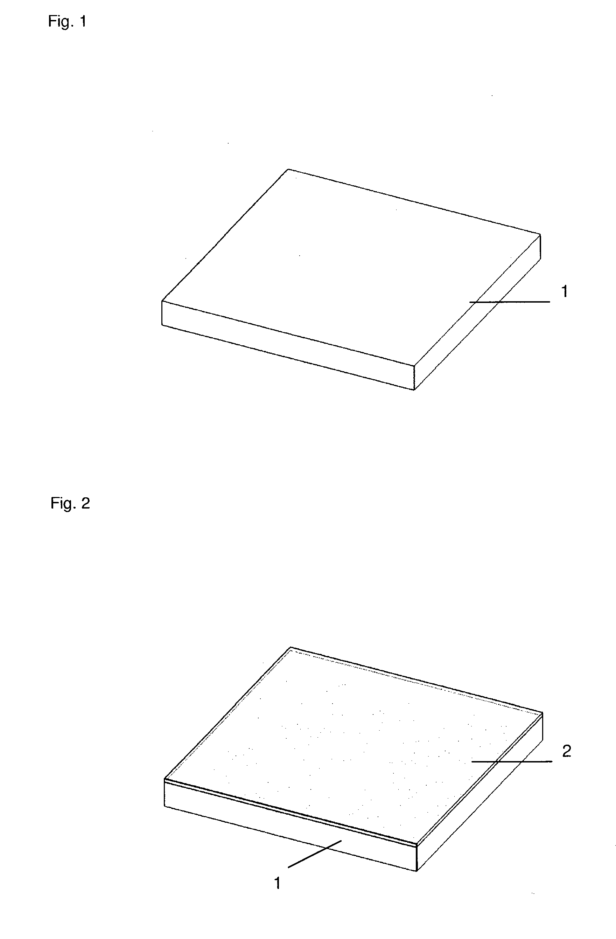

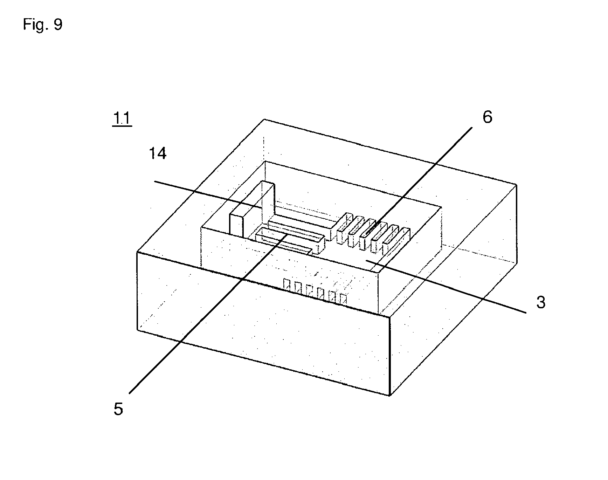

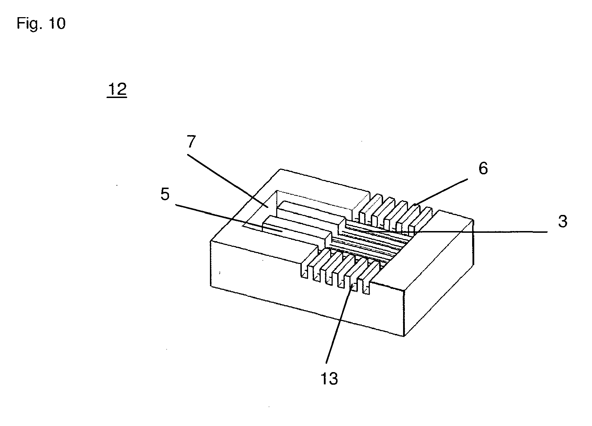

Figs. 1 to 10 show the method of producing a polymer stamp of Fig. 9 and a final product of Fig. 10 according to a first embodiment. Exemplarily, the stamp is formed to produce a component for a fuel cell system. However, other applications like optics are also possible. Thus, the production of the stamp and the final product itself is not limited to fuel cell applications but rather to applications which require the formation of nanostructures along with microstructures.

Fig. 1 shows the first step of the method of producing a polymer stamp with nanostructures and microstructures according to the first embodiment, the provision of a first substrate 1. The first substrate 1 may a silicon wafer, may comprise glass or a thermoplastic polymer, but is not limited thereto. The first substrate 1 may be formed of a single material or material compound or may comprise different layers.

In a second step, nanostructures 3 are transferred into the first substrate surface. This may be done by means of nanolithography processes, preferably by UV lithography, nanoimprint lithography, hot embossing, e-beam lithography, interference lithography, X-ray interference lithography.

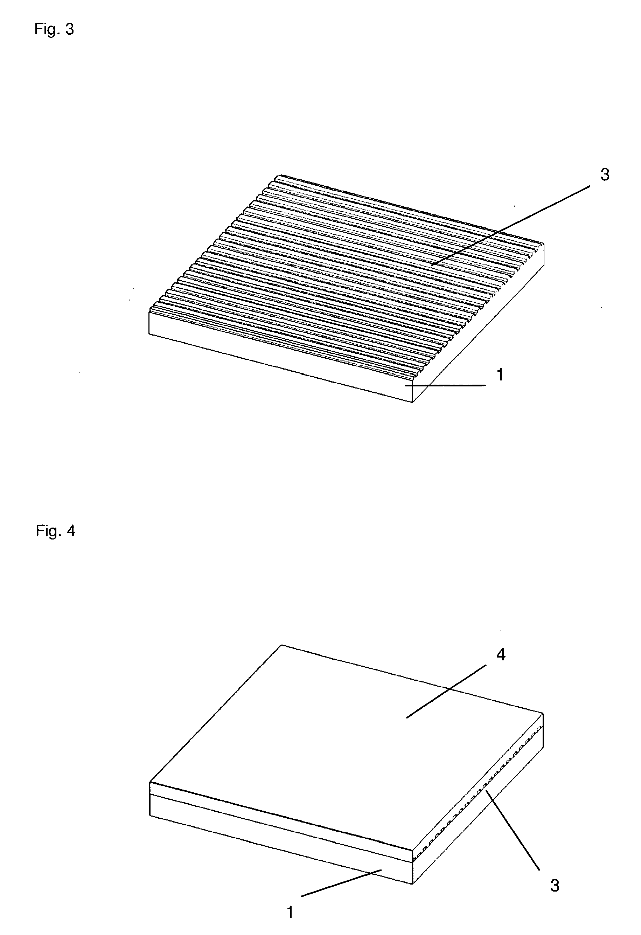

In an exemplary embodiment, the step of patterning nanostructures 3 into the first substrate 1 preferably comprises the steps of covering the first substrate with a first resist as shown in Fig. 2. Then, nanostructures are transferred or formed into the first resist by means of one of the above mentioned nanolithography processes. For instance, the nanostructures may be lines and spaces as shown in Fig. 3. However, the lines may also consist of separate elements like columns, pyramids and so on. The cross section of the lines or the nanostructures 3 may be rectangular, triangular etc.. It is only necessary to provide a smaller spacing of the nanostructures 3 in the desired first direction than in the second, different direction. The first substrate 1 with the nanostructured first resist 2 is subsequently covered with a metal layer (not shown). The first resist 2 is then removed with the metal on top, wherein the areas of the first substrate 1 without the first resist 2 remain covered by the metal. These covered parts act like a mask for an etching process of nanostructures 3 into the parts of the first substrate 1 not covered with the metal. Thus, the etching may form valleys into the surface of the first substrate 1, and the covered parts may remain as plateaus. In other words, if the first resist 2 is patterned with lines, the lines become the bottoms of nanostructured channels, the metal covered parts form spaces between the channels connecting the channel side walls. Finally, the metal is removed from the first substrate 1 as can be seen in Fig. 3 and a nanostructured first substrate surface remains.

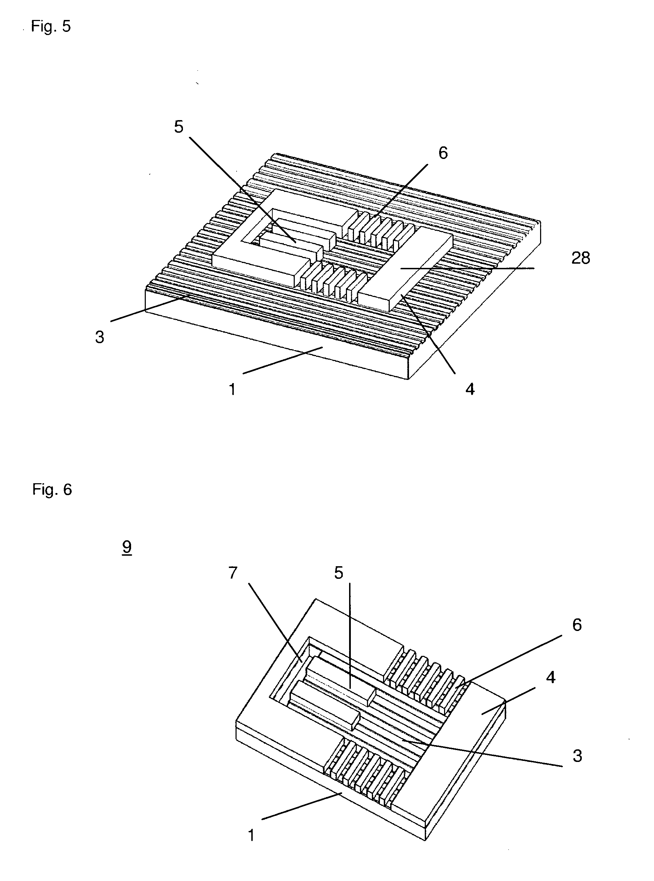

The next step of the fabrication process is shown in Fig. 4, the formation of a second resist 4 on the nanostructures surface of the first substrate 1. The second resist 4 is than patterned to exhibit first microstructures 5 and second microstructures 6 as well as other structures like further side walls 28 (Fig. 5). The structure as displayed in Fig. 5 surrounded by the second resist structures 28 is equivalent to the structure of the final product.

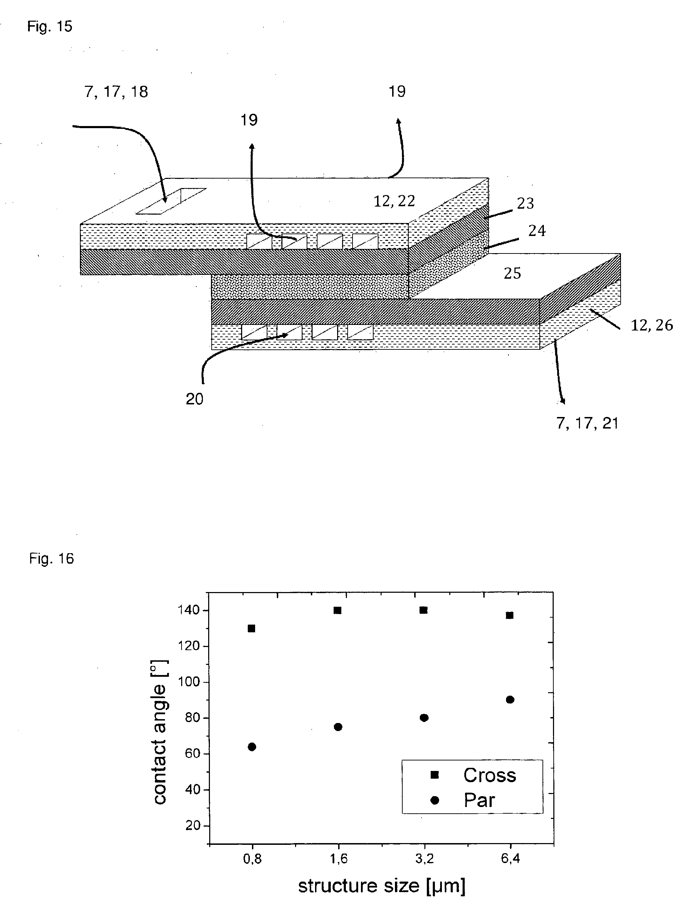

In the present embodiment, in order to, for instance, form a water management system 26 or a fuel delivery system 22 of Fig. 15, the first microstructures 5 are formed along the direction of extension of the nanostructures 3 thereby forming hydrophilic structures for a fluid transport. The second microstructures 6 are formed in a second, perpendicular to the direction of extension of the nanostructures 3 (being the direction of the valleys in Fig. 5) thereby forming hydrophobic structures, which can be used for a liquid/gas separation. The gas is transported along the second microstructures 6 to the periphery of the photo resists structures 4. The first and second microstructures 5, 6 are connected via an area of nanostructures 3, only.

In a preferred embodiment, also a through-hole 7 is formed through the second resist 4 and the first substrate 1. This is preferably done by potassium hydroxide etching, deep reactive ion etching, microdrilling or micromilling, or laser ablation.

The device is then cut along the periphery of the second resist 4 patterns, preferably by a laser. The cut-out device of Fig. 6 could be called a pre-master 9. The pre-master 9 already comprises a through-hole 7, first and second microstructures 5, 6, nanostructures 3 and further side walls 28. The pre-master 9 comprises in the exemplary embodiment the substrate layer 1 with nanostructures 3 in its surface and further structures like first and second microstructures 5, 6 and side walls 28 on its surface.

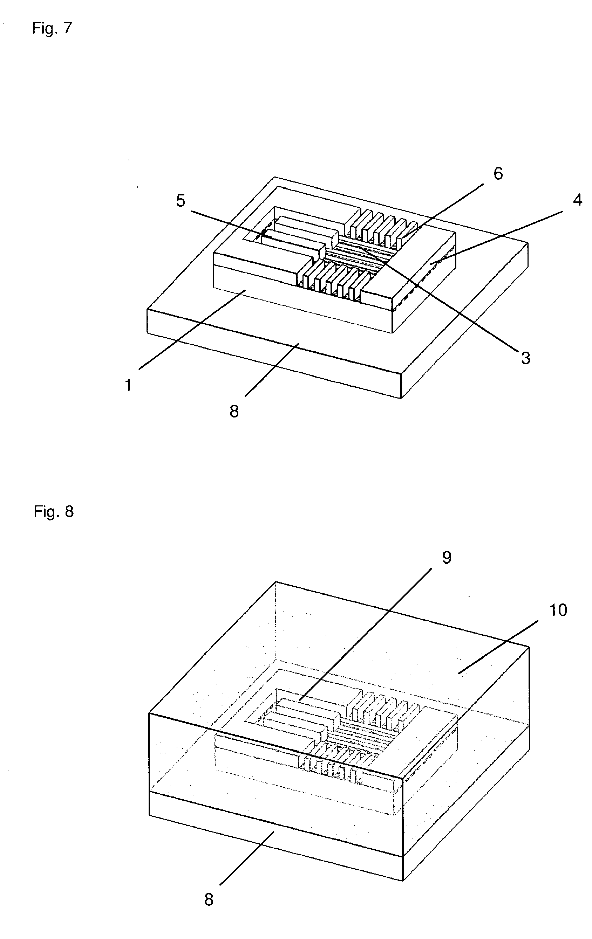

The pre-master 9 is then - preferably but not limiting - fixed on a second substrate 8 (Fig. 7). In a further step, the first casting process takes place, i.e. a polymer material 10 is cast on top of the pre-master 9 attached to the second substrate 8 as shown in Fig. 8. For this, a frame may be used around the pre-master 9. In a final step of producing the polymer stamp 11, the stamp 11 is released from the pre-master 9 (Fig. 9). The polymer stamp 11 now has the inverse structure of the pre-master 9, i.e. were the pre-master 9 had hills, the stamp 11 has valleys and vice versa. In the preferred but not limiting embodiment, also a through hole fabrication structure 14, a column, can be seen.

In a last step, a final product material is filled into the stamp 11 and the final product 12 of Fig. 10 is formed in a casting process. The final product 12 has the same structural elements as the pre-master, i.e. a through-hole 7, first and second microstructures 5, 6, nanostructures 3 and further side walls 28. However, the final product 11 consists of a single material. No substrate is present anymore. During casting, the micro- and nanostructures are transferred to the final product. The final product has openings 13 at its side walls being in communication with second microchannels formed by the second microstructures 6 as side walls and the nanostructures 3 forming the bottom of the microchannels. The first microchannels 5 are perpendicular to the second microchannels 6. The first and second microchannels 5, 6 form a T-like structure. The areas of the first and second microchannels 5, 6 do preferably not overlap with each other, having an area, e.g. rectangular, with nanostructures 3 only in between used for the separation of liquids and gases. As the fuel liquid cannot enter the hydrophobic second microchannels, the gaseous by-products can escape through said microchannels.

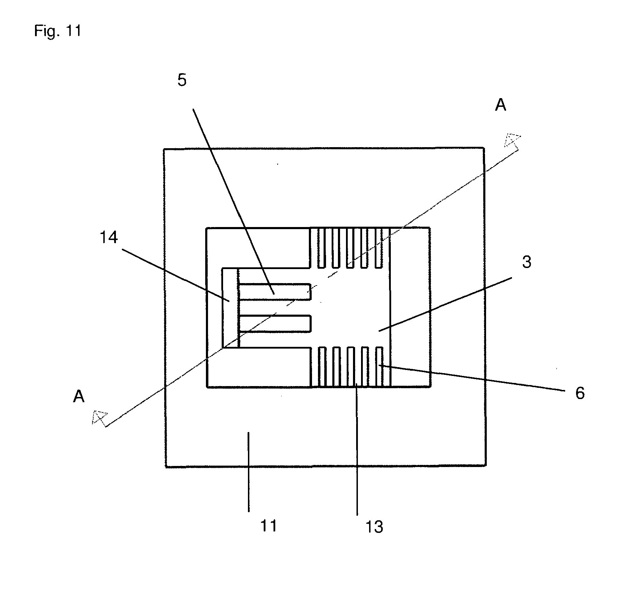

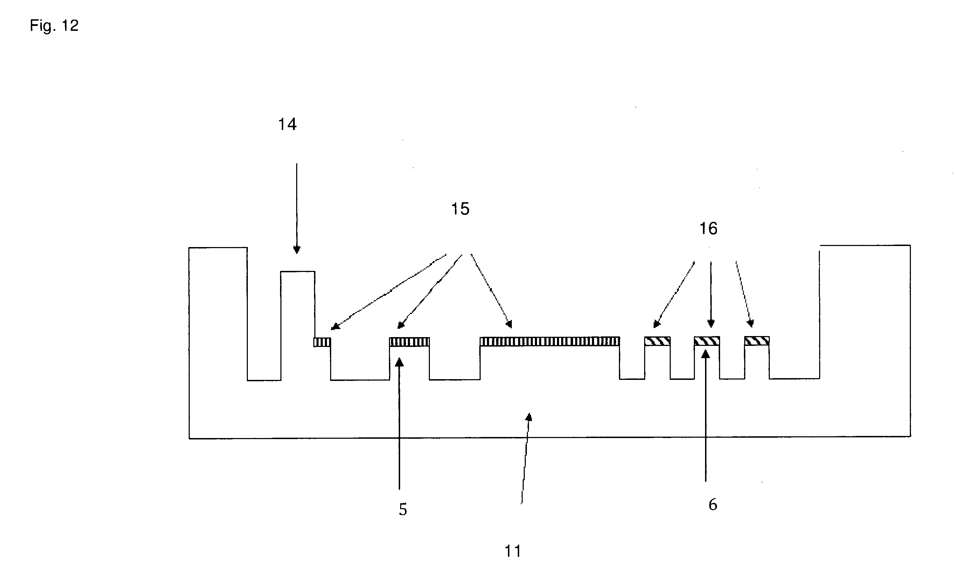

Fig. 11 shows a top view of the polymer stamp of Fig. 9. The nanostructures 3 are not specifically shown in Fig. 11, only their location is pointed out by the reference sign 3. Fig. 12 shows a cut through the stamp of Fig. 11 along the line A-A, a diagonal line starting in a stamp side wall, through the through-hole fabrication structure 14, first microstructures 5, a nanostructured-only area 3 and second microstructures 6. Hydrophilic nanostructured surfaces 15 are formed on top of the structures used for the fabrication of the first microstructures 5. However, it is pointed out that stamp 11 exhibits an inverse structure as that of the final product 12, i.e. a column of the stamp 11 of Fig. 12 is a valley in the final product 12. Thus, in the final product 12, the hydrophilic nanostructured surfaces 15 are the bottom surface of the respective microchannels 5. The same holds for the hydrophobic nanostructured surfaces 16 formed on the inverse second microstructures 6.

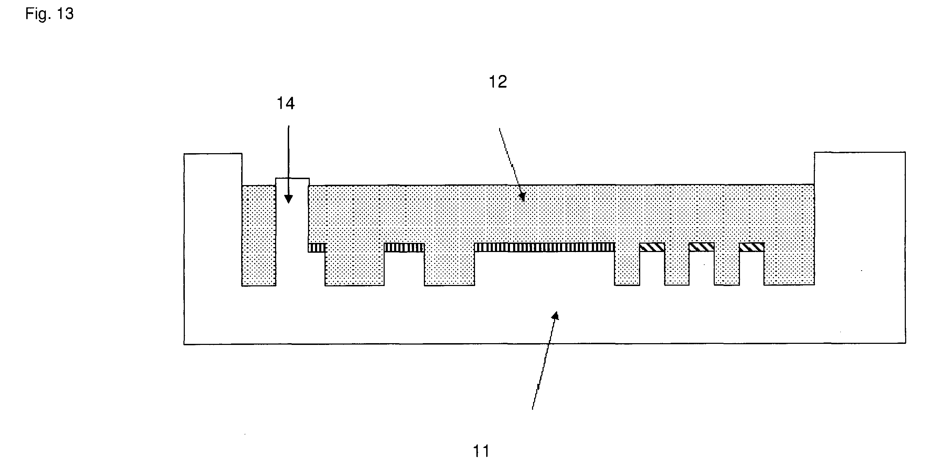

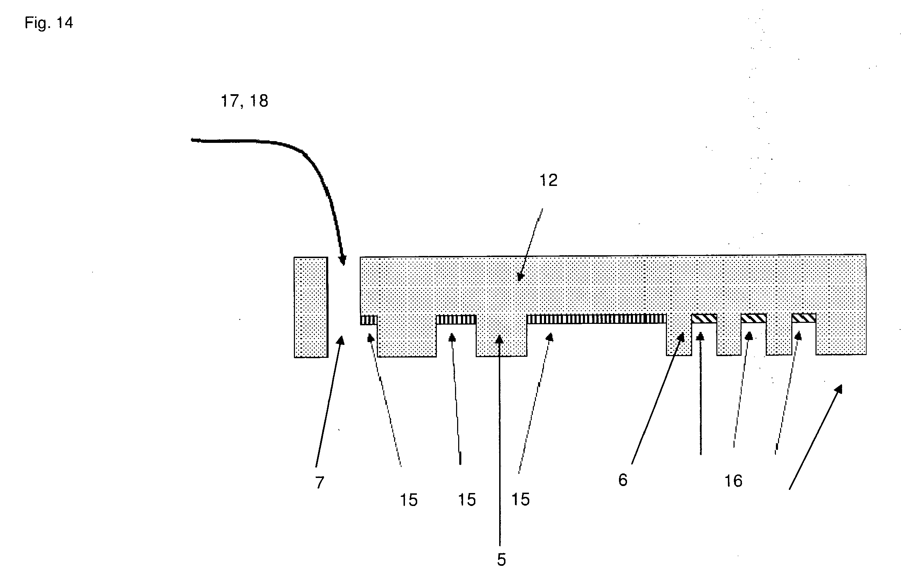

The casting process of the final product 12 is shown in Fig. 13. A final product material is filled into the stamp 11. In order to form a through-hole 7, the level of the final product material does not exceed the top of the through-hole fabrication structure 14. During the casting process, the nanostructures are transferred to the final product 12 as shown in Fig. 14. The through-hole 7 is formed along with the nano- and microstructures 3, 5, 6 in a single casting step. The through-hole 7 could for instance be used as an inlet 17 for fuel 18.

In a specific detailed, not limiting embodiment, the following monomer was used as UV curing second resin 4: a diglycidyl ether of bis-phenol A (DGE-BPA). A triaryl sulfonium salt (TAS) was used as a photoinitiator. As materials for the stamp 11 a poly(dimethylsiloxane) PDMS was used. This type of PDMS is suitable as stamp material for UV applications as its absorption characteristic shows that a relative low absorption takes place.

For the soft stamp fabrication of the detailed, not limiting embodiment, a frame was employed, which is suitable for the fabrication of four inch PDMS stamps 11. For the master fabrication for the 3D stamp 11, a positive first resist 2 was coated on a four inch first substrate 1, a silicon wafer, followed by UV Lithography, Ni evaporation and a lift-off process to define the etch mask for the nanostructures 3. The nanostructures 3 were transferred using a reactive ion etching process followed by nickel removal. The structures exemplarily but not limiting consist of lines and spaces with a width of 800 nm and 1.6 µm, respectively. On this structured first substrate 1, a second exposure using an epoxy-based resin 4 was realized. Here, a 100 µm thick layer of the epoxy-based resin 4 was coated on the first substrate 1 and structured by UV-lithography using a foil mask. In the last step, the so prepared three dimensional structures were separated by a laser cutting technique. Also, a through hole 7 for delivery entrance was realized like that.

In the next step of the detailed, not limiting embodiment, the stamp 11 was fabricated. A PDMS prepolymer was used. For the transfer of nanostructures into a PDMS stamp, the wettability and the viscosity are decisive factors for good replication accuracy. Therefore, the PDMS mixture was diluted to 70 wt% with toluene to lower the viscosity and to enhance the wettability properties. The mixed blend was cast on the the first substrate 1 and the bonded structures on top of the first substrate 1 and left undisturbed for 24 hours to provide enough time for the penetration of the solution into the structure. It was then heated up to 70°C for 30 min to ensure a complete curing and solvent evaporation. After curing, the PDMS stamp could be peeled easily from the structured master. For the replication of nanostructures and microstructures, a mixture of DGE-BPA with 5 wt-% of TAS was used. This mixture was cast onto the PDMS stamp 11 and degassed for 5 min. Then a thin foil of polycarbonate was placed on the stamp 11 to define the surface quality of the replication. The exposure was realized with a dose of 1440 mJ/cm². The cured micro- and nanostructured part could be easily peeled of the master structure and released from the polycarbonate foil.

Fig. 16 shows a fuel cell application of the final product or device 12. Here, the device formed according to the invention is exemplarily but not limiting used a fuel delivery system 22 and as a water management system 26 of a fuel cell. A first device 12 formed according to the invention is placed on top of a first electrode 23, preferably an anode. The through-hole 7 is used as an inlet 17 for fuel 18. The first device 12 is placed upside-down with respect to Fig. 12 onto the first electrode 23 and attached thereto. The first electrode 23 is attached below to a membrane 24 which is attached below to a second electrode 25, preferably a cathode. The cathode 25 is attached below to a second inventive device 12. The second inventive device 12 is oriented as shown in Fig. 12.

The first device 12 is a fuel delivery system 22. Fuel is supplied through-the through hole 7. The through-hole 7 is in communication with first microchannels formed by the first microstructures 5 and the nanostructures 3. They guide a fluid to the membrane 24 were the reaction takes place. Gaseous by-products of the reaction are separated from the fuel 18 through the nanostructures 3 and are guided along second microchannels formed by the second microstructures 6 and the nanostructures 3. On the cathode side, water 21 exits the water management system 26 through the respective through-hole 7. Oxygen as a reactant is fed through the second microchannels to the cathode 25.

The nanostructures 3 are used to change the wetting properties of surfaces. The here presented device 12 uses this effect to integrate hydrophobic and hydrophilic channels 6, 5. Besides, due to the used casting process a through hole 7 could be created to realize a fuel supply 17. Contact angle measurements as shown in Fig. 16 were done to measure an optimized structure size for the realization of the fuel delivery system. In this system it is important that the difference between hydrophobic and hydrophilic properties of the channels is maximized. For instance, lines and spaces structures 3 show different contact angles depending on the direction. For the cross direction, larger contact angles were measured than parallel to the lines.

For an exemplary test, a structure consisting of lines and spaces with a width and pitch of the lines of 800 nm 1,6 µm, 3,2 µm and 6,4 µm were used, respectively. These structures were etched 1 µm deep into the silicon substrate and replicated as described above. The results of the contact angle measurement are summarized in Fig. 16. The largest difference between hydrophobic and hydrophilic behaviour results for structures with a 800 nm and 1,6 µm wide lines and spaces. Besides the measurement of the structured resin, the pure resin and a sample of an unstructured epoxy-based negative photoresist was measured as well. The measurement of the epoxy-based negative photoresist is important because the final structure may be bonded to epoxy-based negative photoresists to achieve closed channels, i. e. to form a cap of the structure. However, different materials may be used. The result of these measurements show, that both materials have a contact angle of about 65° therefore present hydrophilic properties.

Based on the results of the contact angle measurement a design was developed to exploit the effect of the direction depending wetting properties of the structure. Therefore the design was chosen as in Fig. 12. The hydrophilic channel structures 5 were aligned parallel to the nanostructured lines 3 and the hydrophobic channels 6 orthogonal to the lines 3. The channel height may be 100µm. For a test, a drop of a 5 mol-% solution of ethanol was put on the entrance of the device 12. The solution easily passes through the hydrophilic channels 5 and the hydrophilic area adjacent to the channels 5, connecting the hydrophilic channels 5 with the hydrophobic channels 6. However, as the wetting properties of the channels with orthogonal lines differ strongly form those of the channel with parallel lines, the solution is not able to enter the orthogonal channels 6.

Due to this effect a system could be created which can be used as a fuel delivery system for fuel cell applications. The fuel 18 can be transported through the hydrophilic channels 5 to the area in the middle of the structure were it can be provided to the fuel cell. The CO₂ which is produced during the reaction can escape through the hydrophobic channels 6.

Thus, the wetting properties of the channels 5, 6 were changed using nanostructures without any additional chemical treatment

The so obtained final product 12 has the advantage that the nanostructures are not only formed on the bottom of the microchannels, but also on their side and top walls. This further improves the hydrophilic/hydrophobic properties of the channels.

To conclude, the methods according to the invention allow the integration of nanostructures, microstructures and through-hole into a final product in a single casting step.

Although some exemplary embodiments of the present invention have been shown and described herein, it will be appreciated by those skilled in the art that changes may be made from these embodiments without departing from the scope of the invention which is defined in the claims and their equivalents.

### List of reference signs

- 1: first substrate
- 2: first resist
- 3: nanostructures
- 4: second resist
- 5: first microstructures
- 6: second microstructures
- 7: through-hole
- 8: second substrate
- 9: pre-master
- 10: polymer-elastomer material
- 11: polymer stamp
- 12: final product
- 13: outlet/inlet
- 14: through-hole fabrication structure
- 15: hydrophilic nanostructured surfaces
- 16: hydrophobic nanostructured surfaces
- 17: inlet/outlet
- 18: fuel
- 19: by-products
- 20: oxygen
- 21: water
- 22: fuel delivery system
- 23: first electrode
- 24: membrane
- 25: second electrode
- 26: water management / oxygen inlet system
- 27: foil
- 28: side walls

## Claims

1. Method of producing a polymer stamp for the reproduction of devices comprising microstructures and nanostructures, the method comprising the steps of:
providing a first substrate (1);
patterning nanostructures (3) extending along a first direction into the first substrate material (1); followed by
patterning microstructures (5, 6) onto the first substrate (1);
casting a polymer elastomer onto the first substrate (1) with nanostructures (3) and microstructures (5, 6) to form a polymer stamp (11); and
releasing the polymer stamp (11),
**characterized in that**
the step of pattering microstructures (5, 6) comprises at least one of the steps of:
forming first microstructures (5) to extend along the first direction to form hydrophilic channels together with the nanostructures (3) extending in said first direction, and
forming second microstructures (6) to extend along a second direction different from the first direction to form hydrophobic channels together with the nanostructures (3) extending in the first direction.

2. Method of producing a polymer stamp of claim 1, wherein the step of patterning microstructures (5, 6) further comprises at least one of the steps of:
forming the first microstructures (5) with a width of 50-500µm, preferably 100-200µm and a height of 10-1000µm, preferably 50-200µm, and
forming the second microstructures (6) with a width of 1-100µm, preferably 5-50µm and a height of 10-1000µm, preferably 50-200µm.

3. Method of producing a polymer stamp of one of the claims 1 or 2, wherein the step of patterning nanostructures (3) comprises at least one of the steps of:
forming the nanostructures (3) with a pitch of 70nm-3500nm, preferably 500-1000nm and/or a structure cross-section being triangular, rectangular or pillar-shaped, and
forming the nanostructure (3) as lines and spaces extending in the first direction.

4. Method of producing a polymer stamp of claim 1, wherein the step of patterning nanostructures (3) into the first substrate (1) material comprises the steps:
covering the first substrate (1) with a first resist (2);
transferring nanostructures (3) into the first resist (2) by means of nanolithography processes;
covering the first substrate (1) with the nanostructured first resist (2) with a metal layer;
removal of the first resist (2) and the metal on top of the first resist (2), herein the areas of the first substrate (1) without the resist (2) remain covered by the metal;
forming nanostructures (3) into the parts of the first substrate (1) not covered with the metal by etching the surface of the first substrate (1) using the remaining metal as a mask;
removal of the metal from the first substrate (1).

5. Method of producing a polymer stamp of any of the previous claims, wherein the microstructure patterning step comprises at least one of the steps of:
covering the first substrate (1) with a second resist (2) being a photo resist and performing a lithography process to form microstructures in the second resist (2), and
forming a through hole (7) through the second resist (2) and the first substrate (1).

6. Method of producing a polymer stamp of any of the previous claims, wherein the polymer elastomer comprises polydimethylsiloxane.

7. Method of reproducing devices comprising microstructures and nanostructures comprising the steps of:
casting a final product material onto the polymer stamp (11) comprising microstructures (5, 6) and nanostructures (3) produced by any of claims 1 to 6, wherein the microstructures (5, 6) and nanostructures (3) are transferred during the casting step to the final product (12), and
releasing the final product (12) of the polymer stamp (11).

8. Method of reproducing devices according to claim 7, wherein the final product material used for casting is a polymer material.

9. Device comprising:
first microchannels (5) extending along a first direction,
second microchannels (6) extending along a second direction, different from the first direction, and
nanostructures (3) formed at least on the bottom of the first and second microchannels (5, 6) and provided to extend at least along said first direction,
**characterized in that**
a through-hole (7) is provided extending from one surface of the device (12) to be in communication with the microchannels (5, 6),
the nanostructures (3) and the first and second microchannels (5, 6) form hydrophilic channels along the first direction and hydrophobic channels along the second direction, and
the nanostructures (3) are patterned into the surface of the microchannels (5, 6) and are formed of the same material as microchannels (5, 6) themselves.

10. Device of claim 9, wherein the device consists of a single polymer material or a single polymer material compound.

11. Device of claim 9 or 10, wherein the nanostructures (3):
adapted to provide contact angles for a fluid contained therein of 0°-90°, preferably 30°-75° along the first direction and 90°-160°, preferably 110-150° along the second direction, and/or
have a pitch of 70nm-3500nm, preferably 500-1000nm; and/or
are provided with a cross-section being triangular, rectangular or pillar-shaped;
and/or
are provided as lines and spaces extending in the first direction.

12. Device of any of claims 9 to 11, wherein
the first microchannels (5) have a width of 50-500µm, preferably 100-200µm and a height of 10-1000µm, preferably 50-200µm; and/or
the second microchannels (6) have a width of 1-100µm, preferably 5-50µm and a height of 10-1000µm, preferably 50-200µm.

13. Use of the device of one of claims 9 to 12 as a fuel delivery system of a micro fuel cell, wherein the first microchannels (5) are fuel delivery microchannels, and the second microchannels are gas exhaust microchannels and the through-hole is a fuel supply

14. Use of the device of one of claims 9 to 12 as a water management system of a micro fuel cell, wherein the first microchannels (5) are water outlet microchannels, the second microchannels (6) are used as reactant supplies and the through-hole (7) is a water exit.

## Patentansprüche

1. Verfahren zur Herstellung eines Polymerstempels zum Abformen von Vorrichtungen mit Mikro- und Nanostrukturen, umfassend folgende Schritte:
Bereitstellen eines ersten Substrats (1);
Erzeugen von Nanostrukturen (3), die sich entlang einer ersten Richtung in das erste Substratmaterial (1) erstrecken; gefolgt durch
Erzeugen von Mikrostrukturen (5, 6) auf dem ersten Substrat (1);
Gießen eines Polymer-Elastomers auf das erste Substrat (1) mit Nanostrukturen (3) und Mikrostrukturen (5, 6), um einen Polymerstempel (11) auszubilden; und
Ablösen des Polymerstempels (11),
**dadurch gekennzeichnet, dass**
der Schritt des Erzeugens von Mikrostrukturen (5, 6) mindestens einen der folgenden Schritte umfasst:
Ausbilden erster Mikrostrukturen (5), die sich entlang der ersten Richtung erstrecken, um gemeinsam mit den Nanostrukturen (3), die sich in der ersten Richtung erstrecken, hydrophile Kanäle auszubilden, und
Ausbilden zweiter Mikrostrukturen (6), die sich entlang einer zweiten Richtung, die sich von der ersten Richtung unterscheidet, erstecken, um gemeinsam mit den Nanostrukturen (3), die sich in der ersten Richtung erstrecken, hydrophobe Kanäle auszubilden.

2. Verfahren zur Herstellung eines Polymerstempels nach Anspruch 1, wobei der Schritt des Erzeugens von Mikrostrukturen (5, 6) ferner mindestens einen der folgenden Schritte umfasst:
Ausbilden der ersten Mikrostrukturen (5) mit einer Breite von 50 - 500 µm, vorzugsweise 100 - 200 µm, und einer Höhe von 10 - 1.000 µm, vorzugsweise 50 - 200 µm, und
Ausbilden der zweiten Mikrostrukturen (6) mit einer Breite von 1 - 100 µm, vorzugsweise 5 - 50 µm, und einer Höhe von 10 - 1.000 µm, vorzugsweise 50-200 µm.

3. Verfahren zur Herstellung eines Polymerstempels nach einem der Ansprüche 1 oder 2, wobei der Schritt des Erzeugens von Nanostrukturen (3) mindestens einen der folgenden Schritte umfasst:
Ausbilden der Nanostrukturen (3) mit einem Abstand von 70 nm - 3.500 nm, vorzugsweise 500 - 1.000 nm, und/oder einem dreieckigen, rechteckigen oder säulenförmigen Strukturquerschnitt, und
Ausbilden der Nanostrukturen (3) als Linien und Leerstellen, die sich in der ersten Richtung erstrecken.

4. Verfahren zur Herstellung eines Polymerstempels nach Anspruch 1, wobei der Schritt des Erzeugens von Nanostrukturen (3) im ersten Substratmaterial (1) folgende Schritte umfasst:
Abdecken des ersten Substrats (1) mit einem ersten Abdeckmittel (2); Übertragen von Nanostrukturen (3) in das erste Abdeckmittel (2) mit Hilfe von Nanolithografieverfahren;
Abdecken des ersten Substrats (1) mit dem nanostrukturierten ersten Abdeckmittel (2) mit einer Metallschicht;
Entfernen des ersten Abdeckmittels (2) und des Metalls oben auf dem ersten Abdeckmittel (2), wobei die Bereiche des ersten Substrats (1) ohne das Abdeckmittel (2) durch das Metall abgedeckt bleiben;
Ausbilden von Nanostrukturen (3) in den nicht mit dem Metall abgedeckten Teilen des ersten Substrats (1) durch Ätzen der Oberfläche des ersten Substrats (1), wobei das verbleibende Metall als eine Maske genutzt wird;
Entfernen des Metalls vom ersten Substrat (1).

5. Verfahren zur Herstellung eines Polymerstempels nach einem der vorangehenden Ansprüche, wobei der Schritt des Erzeugens von Mikrostrukturen mindestens einen der folgenden Schritte umfasst:
Abdecken des ersten Substrats (1) mit einem zweiten Abdeckmittel (2), das ein Fotoabdeckmittel ist, und Ausführen eines Lithografieverfahrens, um Mikrostrukturen im zweiten Abdeckmittel (2) auszubilden, und
Ausbilden eines Durchgangslochs (7) durch das zweite Abdeckmittel (2) und das erste Substrat (1).

6. Verfahren zur Herstellung eines Polymerstempels nach einem der vorangehenden Ansprüche, wobei das Polymer-Elastomer Polydimethylsiloxan enthält.

7. Verfahren zum Abformen von Vorrichtungen mit Mikro- und Nanostrukturen, umfassend folgende Schritte:
Gießen eines Endproduktmaterials auf den Polymerstempel (11) mit Mikrostrukturen (5, 6) und Nanostrukturen (3), der nach einem der Ansprüche 1 bis 6 hergestellt wurde, wobei die Mikrostrukturen (5, 6) und Nanostrukturen (3) während des Schrittes des Gießens auf das Endprodukt (12) übertragen werden, und
Ablösen des Endprodukts (12) vom Polymerstempel (11).

8. Verfahren zum Abformen von Vorrichtungen nach Anspruch 7, wobei das für das Gießen verwendete Endproduktmaterial ein Polymermaterial ist.

9. Vorrichtung, umfassend:
erste Mikrokanäle (5), die sich entlang einer ersten Richtung erstrecken,
zweite Mikrokanäle (6), die sich entlang einer zweiten, von der ersten Richtung abweichenden Richtung erstrecken, und
Nanostrukturen (3), die zumindest auf dem Boden der ersten und zweiten Mikrokanäle (5, 6) ausgebildet sind und bereitgestellt sind, um sich mindestens entlang der ersten Richtung zu erstrecken,
**dadurch gekennzeichnet, dass**
ein Durchgangsloch (7) bereitgestellt ist, das sich von einer Fläche der Vorrichtung (12) erstreckt, um mit den Mikrokanälen (5, 6) in Verbindung zu stehen,
die Nanostrukturen (3) und die ersten und zweiten Mikrokanäle (5, 6) entlang der ersten Richtung hydrophile Kanäle und entlang der zweiten Richtung hydrophobe Kanäle bilden, und
die Nanostrukturen (3) in der Oberfläche der Mikrokanäle (5, 6) erzeugt werden und aus demselben Material wie die Mikrokanäle (5, 6) selbst ausgebildet sind.

10. Vorrichtung nach Anspruch 9, wobei die Vorrichtung aus einem einzigen Polymermaterial oder einem einzigen Polymermaterialverbund besteht.

11. Vorrichtung nach Anspruch 9 oder 10, wobei die Nanostrukturen (3):
geeignet sind, um Kontaktwinkel für eine darin enthaltene Flüssigkeit von 0°-90°, vorzugsweise 30 ° - 75 °, entlang der ersten Richtung, und von 90 ° - 160 °, vorzugsweise 110 - 150°, entlang der zweiten Richtung bereitzustellen, und/oder einen Abstand von 70 nm - 3.500 nm, vorzugsweise 500 - 1.000 nm, aufweisen und/oder
mit einem dreieckigen, rechteckigen oder säulenförmigen Querschnitt bereitgestellt sind und/oder
als Linien und Räume, die sich in der ersten Richtung erstrecken, bereitgestellt sind.

12. Vorrichtung nach einem der Ansprüche 9 bis 11, wobei
die ersten Mikrokanäle (5) eine Breite von 50 - 500 µm, vorzugsweise 100 - 200 µm, und eine Höhe von 10 - 1.000 µm, vorzugsweise 50 - 200 µ, aufweisen und/oder
die zweiten Mikrokanäle (6) eine Breite von 1 - 100 µm, vorzugsweise 5 - 50 µm, und eine Höhe von 10 - 1.000 µm, vorzugsweise 50 - 200 µm, aufweisen.

13. Verwendung der Vorrichtung nach einem der Ansprüche 9 bis 12 als ein Brennstoffzufuhrsystem einer Mikrobrennstoffzelle, wobei die ersten Mikrokanäle (5) Brennstoffzufuhrmikrokanäle sind und die zweiten Mikrokanäle Gasabfuhrmikrokanäle sind und das Durchgangsloch eine Brennstoffzuleitung ist.

14. Verwendung der Vorrichtung nach einem der Ansprüche 9 bis 12 als ein Wassermanagementsystem, wobei die ersten Mikrokanäle (5) Wasserauslassmikrokanäle sind, die zweiten Mikrokanäle (6) als Reaktantzuleitungen genutzt werden sind und das Durchgangsloch (7) ein Wasseraustritt ist.

## Revendications

1. Procédé de production d'un timbre en polymère pour la reproduction de dispositifs comprenant des microstructures et des nanostructures, le procédé comprenant les étapes suivantes :
la fourniture d'un premier substrat (1) ;
la structuration de nanostructures (3) s'étendant le long d'une première direction dans le premier matériau de substrat (1) ; suivie de
la structuration de microstructures (5, 6) sur le premier substrat (1) ;
le coulage d'un élastomère polymère sur le premier substrat (1) avec des nanostructures (3) et des microstructures (5, 6) pour former un timbre en polymère (11);et
la libération du timbre en polymère (11),
**caractérisé en ce que**
l'étape de structuration de microstructures (5, 6) comprend au moins une des étapes suivantes :
la formation de premières microstructures (5) pour qu'elles s'étendent le long de la première direction pour former des canaux hydrophiles de concert avec les nanostructures (3) s'étendant dans ladite première direction, et
la formation de deuxièmes microstructures (6) pour qu'elles s'étendent le long d'une deuxième direction différente de la première direction pour former des canaux hydrophobes de concert avec les nanostructures (3) s'étendant dans la première direction.

2. Procédé de production d'un timbre en polymère selon la revendication 1, dans lequel l'étape de structuration de microstructures (5, 6) comprend en outre au moins une des étapes suivantes :
la formation des premières microstructures (5) avec une largeur de 50 - 500 µm, de préférence de 100 - 200 µm, et une hauteur de 10 - 1000 µm, de préférence de 50 - 200 µm, et
la formation des deuxièmes microstructures (6) avec une largeur de 1 - 100 µm, de préférence de 5 - 50 µm, et une hauteur de 10 - 1000 µm, de préférence de 50 - 200 µm.

3. Procédé de production d'un timbre en polymère selon l'une des revendications 1 ou 2, dans lequel l'étape de structuration de nanostructures (3) comprend au moins une des étapes suivantes :
la formation des nanostructures (3) avec un pas de 70 nm - 3500 nm, de préférence 500 - 1000 nm, et/ou une section transversale de structure triangulaire, rectangulaire ou en forme de pilier, et
la formation des nanostructures (3) en tant que lignes et espaces s'étendant dans la première direction.

4. Procédé de production d'un timbre en polymère selon la revendication 1, dans lequel l'étape de structuration de nanostructures (3) dans le matériau du premier substrat (1) comprend les étapes suivantes :
la couverture du premier substrat (1) avec une première réserve (2) :
le transfert de nanostructures (3) dans la première réserve (2) au moyen de processus de nanolithographie ;
la couverture du premier substrat (1) muni de la première réserve (2) nanostructurée avec une couche métallique ;
l'enlèvement de la première réserve (2) et du métal au sommet de la première réserve (2), où les surface du premier substrat (1) dépourvues de la première réserve (2) demeurent couvertes par le métal ;
la formation de nanostructures (3) dans les parties du premier substrat (1) non couvertes par le métal par gravure de la surface du premier substrat (1) en utilisant le métal restant comme masque ;
l'enlèvement du métal à partir du premier substrat (1).

5. Procédé de production d'un timbre en polymère selon l'une quelconque des revendications précédentes, dans lequel l'étape de structuration des microstructures comprend au moins une des étapes suivantes :
la couverture du premier substrat (1) avec une deuxième réserve (2) qui est une résine photosensible et la réalisation d'un processus de lithographie pour former des microstructures dans la deuxième réserve (2), et
la formation d'un trou débouchant (7) à travers la deuxième réserve (2) et le premier substrat (1).

6. Procédé de production d'un timbre en polymère selon l'une quelconque des revendications précédentes, dans lequel l'élastomère polymère comprend du polydiméthylsiloxane.

7. Procédé de reproduction de dispositifs comprenant des microstructures et des nanostructures, comprenant les étapes suivantes :
le coulage d'un matériau de produit final sur le timbre en polymère (11) comprenant des microstructures (5, 6) et des nanostructures (3) produites selon l'une quelconque des revendications 1 à 6, dans lequel les microstructures (5, 6) et les nanostructures (3) sont transférées pendant l'étape de coulage au produit final (12), et
la libération du produit final (12) du timbre en polymère (11).

8. Procédé de reproduction de dispositifs selon la revendication 7, dans lequel le matériau de produit final utilisé pour le coulage est un matériau polymère.

9. Dispositif, comprenant :
des premiers microcanaux (5) s'étendant le long d'une première direction,
des deuxièmes microcanaux (6) s'étendant le long d'une deuxième direction, différente de la première direction, et
des nanostructures (3) formées au moins sur le fond des premiers et deuxièmes microcanaux (5, 6) et prévues pour s'étendre au moins le long de ladite première direction,
**caractérisé en ce**
**qu'**un trou débouchant (7) est prévu, qui s'étend à partir d'une surface du dispositif (12) pour être en communication avec les microcanaux (5, 6),
les nanostructures (3) et les premiers et deuxièmes microcanaux (5, 6) forment des canaux hydrophiles le long de la première direction et des canaux hydrophobes le long de la deuxième direction, et
les nanostructures (3) sont structurées dans la surface des microcanaux (5, 6) et sont formées du même matériau que les microcanaux (5, 6) eux-mêmes.

10. Dispositif selon la revendication 9, dans lequel le dispositif consiste en un matériau polymère unique ou en un composite de matériau polymère unique.

11. Dispositif selon la revendication 9 ou 10, dans lequel les nanostructures (3) :
sont adaptées pour fournir des angles de contact de 0-90 ° pour un fluide qui y est contenu, de préférence de 30 ° - 75 °, le long de la première direction et de 90 °-160 °, de préférence 110 °- 150 °, le long de la deuxième direction, et/ou ont un pas de 70 nm - 3500 nm, de préférence 500 - 1000 nm ; et/ou
sont munies d'une section transversale triangulaire, rectangulaire ou en forme de pilier ; et/ou
sont prévues en tant que lignes et espaces s'étendant dans la première direction.

12. Dispositif selon l'une quelconque des revendications 9 à 11, dans lequel les premiers microcanaux (5) ont une largeur de 50 - 500 µm, de préférence de 100 - 200 µm, et une hauteur de 10 - 1000 µm, de préférence de 50 - 200 µm ; et/ou les deuxièmes microcanaux (6) ont une largeur de 1 - 100 µm, de préférence de 5-50 µm, et une hauteur de 10 - 1000 µm, de préférence de 50 - 200 µm.

13. Utilisation du dispositif selon l'une des revendications 9 à 12 en tant que système de fourniture de combustible d'une micro-pile à combustible, dans laquelle les premiers microcanaux (5) sont des microcanaux de fourniture de combustible, et les deuxièmes microcanaux sont des microcanaux d'évacuation des gaz, et le trou débouchant est une alimentation en combustible.

14. Utilisation du dispositif selon l'une des revendications 9 à 12 en tant que système de gestion de l'eau d'une micro-pile à combustible, dans laquelle les premiers microcanaux (5) sont des microcanaux d'évacuation d'eau, les deuxièmes microcanaux (6) sont utilisés comme alimentations en réactifs et le trou débouchant (7) est une sortie d'eau.
